# EUROPÄISCHE PATENTSCHRIFT

(11) **EP 0 602 278 B1**
(45) Veröffentlichungstag und Bekanntmachung des Hinweises auf die Patenterteilung: **11.03.1998**
(21) Anmeldenummer: 92121628.9
(22) Anmeldetag: 18.12.1992
(51) Int. Cl.: H01L 23/66, H01L 23/047

(54) **Bipolarer Hochfrequenztransistor**
High frequency bipolar transistor
Transistor bipolaire à haute fréquence

(43) Veröffentlichungstag der Anmeldung: 22.06.1994
(73) Patentinhaber: SIEMENS AKTIENGESELLSCHAFT, 80333 München (DE)
(72) Erfinder: Brenndörfer, Knut, Dipl.-Ing., W-8045 Ismaning (DE); Huber, Jakob, Dipl.-Phys., W-8201 Beyharting (DE)

(56) Entgegenhaltungen:
- EP-A- 0 439 652
- DE-A- 1 914 442
- PATENT ABSTRACTS OF JAPAN vol. 8, no. 285 (E-287)26. Dezember 1984 & JP-A-59 152 650

## Beschreibung

Die Erfindung betrifft einen bipolaren Hochfrequenztransistor mit einem geeignet dotierten und strukturierten, eine Basis-, Kollektor- und Emitterkontaktierung aufweisenden Halbleiterchip aus einem dotierten Silizium-Substrat, der von einem Gehäuse eingeschlossen ist und dessen Kontaktierung mit dem jeweiligen Basis-, Kollektor- und Emitteranschluß des Gehäuses verbunden ist.

Diskrete Halbleiterbauelemente ermöglichen die Optimierung einzelner Leistungsmerkmale für spezifische Schaltungsanwendungen. Im Gegensatz dazu sind bei integrierten Schaltungen aus prozeßtechnischen Gründen meist einschränkende Kompromisse nötig. Speziell für die moderne Kommunikations- und Konsumerelektronik, die zunehmend den Frequenzbereich oberhalb 1 GHz erschließt, sind spezialisierte Einzeltransistoren als Ergänzung integrierter Schaltungen unerläßlich.

Als aktive Einzelbauelemente im genannten Anwendungsbereich stehen für Schaltungen bis ca. 4 GHz Si-npn-Transistoren zur Verfügung. Für noch höhere Frequenzen existieren Transistoren auf GaAs-Substrat, insbesondere in Form von unipolaren Transistoren bzw. Feldeffekttransistoren. Es ist aber von erheblichem wirtschaftlichen Interesse, den Einsatzbereich für diskrete Siliziumtransistoren zu erweitern, zumal Silizium-Scheiben wesentlich billiger bearbeitet werden können als Galliumarsenid-Scheiben.

Obwohl auf dem Markt eine sehr breite Palette von diskreten Si-Hochfrequenztransistoren angeboten wird, weisen doch alle eine gemeinsame Bauweise auf: Das Silizium-Substrat des aktiven Chips dient als Kollektoranschluß. Dabei wird das beispielsweise n⁺-dotierte Silizium-Substrat mit seiner Kollektorkontaktierung (Metallisierung) auf der Unterseite des Chips mit dem Kollektoranschluß des Gehäuses verbunden bzw. auf diesem angeordnet und befestigt. Emitter- und Basisanschlüsse zum Halbleiter sind in sehr feinen Geometrien (≤ 1µm) auf der Oberseite des Chips ausgeführt. Dabei sind die Emitter- und Basisanschlüsse beispielsweise in Form einer interdigitalen Metallisierungsstruktur auf den dotierten Emitter- und Basisgebieten an der Oberfläche des Halbleiterchips aufgebracht. Diese Emitter- und Basiskontaktierungen sind dann jeweils über einen Bonddraht mit dem zugehörigen Emitter- bzw. Basisanschluß des Gehäuses verbunden. Solche Si-Chips werden beispielsweise in SMD (Surface Mounted Device)-Gehäuse eingebaut, wobei der Gehäuseanschluß, auf dem der Si-Chip aufgebracht wird, den Kollektoranschluß des Gehäuses definiert. Emitter und Basis werden über Golddrähte an die restlichen Anschlüsse des Gehäuses gebondet. Sowohl der Chip als auch die Bonddrähte sind durch das Gehäuse geschützt. Solche Hochfrequenz transistoren sind z.B. in den Druckschriften EP-A- 0 439 652 und DE-A- 1 914 442 beschrieben.

Der Anwendungsbereich solcher Bauelemente wird durch die Grenzfrequenz f_{T} charakterisiert, die bei kommerziell erhältlichen Si-Hochfrequenztransistoren bis 10 GHz reicht. Eine weitere Erhöhung der Grenzfrequenz erfordert eine Verbesserung der Chiptechnologie, beispielsweise durch feinere Strukturen oder flachere Dotierprofile.

Für ein verkaufsfertiges Hochfrequenz-Bauelement ist jedoch nicht nur die Leistungsfähigkeit des Silizium-Chips von Bedeutung. Vielmehr gewinnt bei Frequenzen über 1GHz das Gehäuse entscheidende Bedeutung. Es ist als Hochfrequenz-Netzwerk zu betrachten, das die außen am Gehäuse anliegenden Impedanzen an den Chip transformiert. Insbesondere begrenzt die Induktivität im Emitterzweig, die notwendigerweise durch lange Bonddrähte und Gehäuse-Weglängen entsteht, die außen gewinnbare Verstärkung.

Versuche der Gehäuseoptimierung, mehrfache Emitterbondung usw. bringen nur marginale Verbesserungen. Ein Vergleich zweier Chips mit 40 GHz bzw. 8 GHz in der beschriebenen, sogenannten Common-Collector-Bauweise zeigt deutlich, daß die weitaus besseren Eigenschaften des 40 GHz-Chips vom Gehäuse absorbiert werden. Obwohl die genannten Leistungsdaten durch geeignete Meßmethoden "on wafer" nachgewiesen sind, ist es nach dem bisherigen Common-Collector-Konzept doch nicht möglich, die gewünschten Hochfrequenz-Eigenschaften an fertig eingehäusten Transistoren zu erreichen.

Der Erfindung liegt die Aufgabe zugrunde, einen bipolaren Hochfrequenztransistor zu schaffen, der mit einem Gehäuse versehen eine hohe Verstärkung bei Frequenzen oberhalb von 1 GHz ermöglicht.

Diese Aufgabe wird bei einem bipolaren Hochfrequenztransistor der eingangs genannten Art erfindungsgemäß dadurch gelöst, daß die Basis-, Kollektor- und Emitterkontaktierung an der Oberseite des Halbleiterchips vorgesehen ist, daß der Halbleiterchip mit seiner Unterseite auf dem Emitteranschluß des Gehäuses angeordnet ist, der als HF-Masse ausgebildet ist, daß die Emitterkontaktierung in kurzem Abstand mit dem Emitteranschluß des Gehäuses verbunden ist, und daß die Basiskontaktierung mit dem Basisanschluß und die Kollektorkontaktierung mit dem Kollektoranschluß jeweils über mindestens einen Bonddraht miteinander verbunden sind.

Die Emitterkontaktierung auf der Oberseite des Halbleiterchips ist dabei mit dem Emitteranschluß des Gehäuses, auf dem der Chip mit seiner Unterseite befestigt ist, über mindestens einen Bonddraht verbunden. Es kann auch vorteilhaft sein, die Emitterkontaktierung durch den Halbleiterchip hindurch mit dem Emitteranschluß des Gehäuses zu verbinden, um so die kürzest mögliche Verbindung zwischen Emitterkontakt und Emitteranschluß des Chips zu realisieren. Eine hierzu geeignete Methode ist die sogenannte Substrat-via-Technik, bei der durch das Substrat hindurch ein Loch geätzt wird, das dann mit einem geeigneten Metall als Verbindungsmedium aufgefüllt wird.

Das Silizium-Substrat des Halbleiterchips ist im Bereich der mit dem Emitteranschluß zu verbindenden Unterseite zweckmäßig p-dotiert.

Der aktive Halbleiterchip ist vorteilhaft in ein oberflächenmontierbares, ein sogenanntes SMD-Gehäuse eingebaut, das vorzugsweise aus Plastik besteht. Es kann auch zweckmäßig sein, den Emitteranschluß des Gehäuses mehrfach aus dem Gehäuse herauszuführen.

Die mit der Erfindung erzielten Vorteile bestehen insbesondere darin, daß von dem bisherigen Common-Collector-Konzept abgegangen wird, und statt dessen eine Common-Emitter-Konfiguration eingeführt wird. Denn es ist von entscheidender Bedeutung, die äußere Hochfrequenzmasse möglichst unmittelbar an den aktiven Teil des Transistors heranzuführen, und damit den Emitter zu erden. Nach diesem neuen Konzept wird der Silizium-Körper mit dem Emitter-Potential, d.h. mit der HF-Masse, verbunden und der Halbleiterchip auf den Emitteranschluß des Gehäuses montiert. Folglich ist der Kollektoranschluß des Transistorchips zusätzlich an der Oberseite des Chips herauszuführen und an einen entsprechenden Gehäuseanschluß zu bonden. Die elektrische Verbindung des Emitters zum Gehäuseanschluß kann vorzugsweise über möglichst kurze Bonddrähte von der Chip-Oberseite nach unten oder über das Substrat durch geätzte und mit Metall gefüllte Löcher hindurch erfolgen. Der Basis-Anschluß erfolgt in herkömmlicher Bauweise. Da die Emitterkontaktierung der Chipoberseite auf dem gleichen Potential liegt wie das Substrat, kann die Fläche der Emittermetallisierung ohne zusätzliche Parasitärkapazität vergrößert werden. Daher ist eine Mehrfachbondung des Emitters mit niedriger Induktivität möglich.

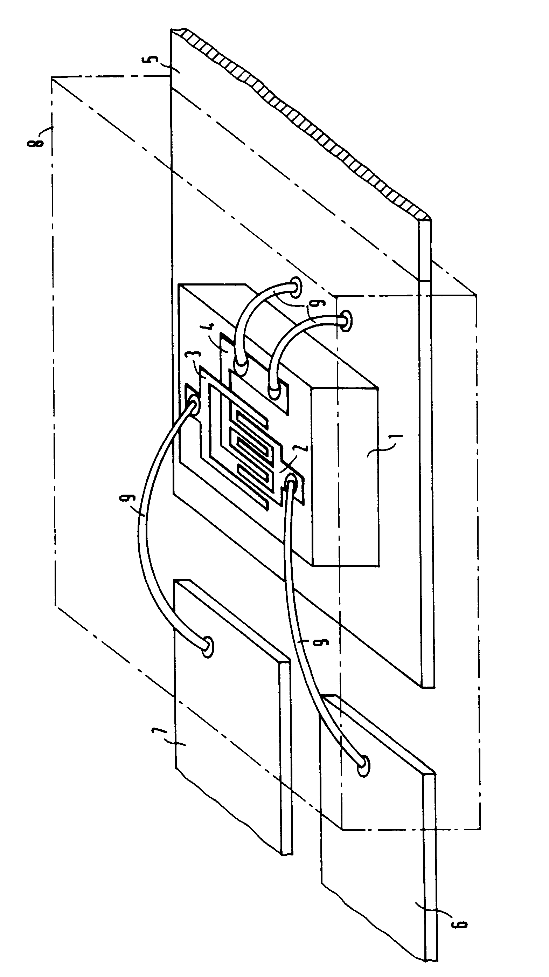

Anhand eines in der Figur der Zeichnung schematisch dargestellten Ausführungsbeispiels wird die Erfindung im folgenden weiter erläutert.

Der in der Figur dargestellte bipolare Hochfrequenztransistor besteht aus einem Halbleiterchip 1 aus einem zweckmäßig p-dotierten Silizium-Substrat. An seiner Oberseite ist der Halbleiterchip 1 in an sich bekannter Weise geeignet dotiert und strukturiert, um die gewünschte, in diesem Beispiel fingerförmige Basis- und Emitter-, aber auch Kollektorkontaktierung 2, 4; 3 auf dessen Oberseite zu realisieren. Mit seiner Unterseite, in diesem Beispiel dem p-dotierten Silizium-Substrat, ist der Halbleiterchip 1 auf dem Emitteranschluß 5 des Gehäuses 8 beispielsweise durch Kleben befestigt. Der Emitteranschluß 5 ist als Hochfrequenzmasse ausgebildet, d.h. er besitzt eine möglichst niedrige Impedanz. Erreicht wird das dadurch, daß der Emitteranschluß 5 möglichst breit und nach außen möglichst kurz bemessen ist. Außerdem sollte der Emitteranschluß 5 des Gehäuses 8 eine möglichst hohe elektrische Leitfähigkeit aufweisen. Beispielsweise besteht der Emitteranschluß 5 aus Kupfer, das zweckmäßig versilbert oder vergoldet ist. Die Emitterkontaktierung 4 ist mit dem Emitteranschluß 5 in möglichst kurzem Abstand verbunden. Im Ausführungsbeispiel erfolgt die kurze Verbindung über zwei Bonddrähte 9, die beispielsweise aus Gold bestehen. Auch die beiden anderen Metallisierungen, d.h. die Kollektorkontaktierung 3 und die Basiskontaktierung 2 des Halbleiterchips 1 sind jeweils über Bonddrähte 9 mit dem jeweiligen Gehäuseanschluß des Transistors, d.h. mit dem Kollektoranschluß 7 bzw. dem Basisanschluß 6 verbunden. Das Gehäuse 8, das sowohl den Halbleiterchip 1 und die Bonddrähte 9, als auch die Innenteile eines sogenannten Leadframes, die den Basisanschluß 6, Kollektoranschluß 7 und Emitteranschluß 5 des Transistors bilden, hermetisch dicht umschließt, besteht vorzugsweise aus Plastik. Das Gehäuse 8 ist zweckmäßig ein sogenanntes SMD-Gehäuse. Zu diesem Zweck sind die nach außen ragenden Teile der elektrischen Anschlüsse 5, 6 und 7 des Hochfrequenztransistors in geeigneter, nicht dargestellter Weise abgewinkelt.

## Patentansprüche

1. Bipolarer Hochfrequenztransistor mit einem geeignet dotierten und strukturierten, eine Basis-, Kollektor- und Emitterkontaktierung aufweisenden Halbleiterchip aus einem dotierten Silizium-Substrat, der von einem Gehäuse eingeschlossen ist und dessen Kontaktierungen dem jeweiligen Basis-, Kollektor- und Emitteranschluß des Gehäuses verbunden sind, wobei die Basis-, die Kollektor- und die Emitterkontaktierung (2, 3, 4) an der Oberseite des Halbleiterchips (1) vorgesehen sind, der Halbleiterchip (1) mit seiner Unterseite auf dem Emitteranschluß (5) des Gehäuses (8) angeordnet ist, der als HF-Masse ausgebildet ist, die Emitterkontaktierung (4) in kurzem Abstand mit dem Emitteranschluß (5) des Gehäuses (8) verbunden ist, und die Basiskontaktierung (2) mit dem Basisanschluß (6) und die Kollektorkontaktierung (3) mit dem Kollektoranschluß (7) jeweils über mindestens einen Bonddraht (9) miteinander verbunden sind.

2. Bipolarer Hochfrequenztransistor nach Anspruch 1, **dadurch gekennzeichnet,** daß die Emitterkontaktierung (4) mit dem Emitteranschluß (5) des Gehäuses (8) über mindestens einen Bonddraht (9) verbunden ist.

3. Bipolarer Hochfrequenztransistor nach Anspruch 1, **dadurch gekennzeichnet**, daß die Emitterkontaktierung (4) durch den Halbleiterchip (1) hindurch mit dem Emitteranschluß (5) des Gehäuses (8) verbunden ist.

4. Bipolarer Hochfrequenztransistor nach einem der Ansprüche 1 bis 3, **dadurch gekennzeichnet**, daß das Silizium-Substrat des Halbleiterchips (1) p-dotiert ist.

5. Bipolarer Hochfrequenztransistor nach einem der Ansprüche 1 bis 4, **dadurch gekennzeichnet**, daß das Gehäuse (8) ein SMD-Gehäuse ist.

6. Bipolarer Hochfrequenztransistor nach einem der Ansprüche 1 bis 5, **dadurch gekennzeichnet**, daß das Gehäuse (8) ein Plastikgehäuse ist.

7. Bipolarer Hochfrequenztransistor nach einem der Ansprüche 1 bis 6, **dadurch gekennzeichnet**, daß der Emitteranschluß (5) des Gehäuses (8) mehrfach aus dem Gehäuse (8) geführt ist.

## Claims

1. Radio-frequency bipolar transistor having a suitably doped and structured semiconductor chip which has a base contact, a collector contact and an emitter contact, comprises a doped silicon substrate, is enclosed by a housing and whose contacts are connected to the respective base terminal, collector terminal and emitter terminal of the housing, the base contact, the collector contact and the emitter contact (2, 3, 4) being provided on the top side of the semiconductor chip (1), the semiconductor chip (1) being arranged with its underside on the emitter terminal (5) of the housing (8), which emitter terminal is designed as RF earth, the emitter contact (4) being connected at a short distance to the emitter terminal (5) of the housing (8), and the base contact (2) being connected to the base terminal (6) and the collector contact (3) being connected to the collector terminal (7) , each of these connections being effected via at least one bonding wire (9).

2. Radio-frequency bipolar transistor according to Claim 1, characterized in that the emitter contact (4) is connected to the emitter terminal (5) of the housing (8) via at least one bonding wire (9).

3. Radio-frequency bipolar transistor according to Claim 1, characterized in that the emitter contact (4) is connected through the semiconductor chip (1) to the emitter terminal (5) of the housing (8).

4. Radio-frequency bipolar transistor according to one of Claims 1 to 3, characterized in that the silicon substrate of the semiconductor chip (1) is p-doped.

5. Radio-frequency bipolar transistor according to one of Claims 1 to 4, characterized in that the housing (8) is an SMD housing.

6. Radio-frequency bipolar transistor according to one of Claims 1 to 5, characterized in that the housing (8) is a plastic housing.

7. Radio-frequency bipolar transistor according to one of Claims 1 to 6, characterized in that the emitter terminal (5) of the housing (8) is routed out of the housing (8) a number of times.

## Revendications

1. Transistor bipolaire à haute fréquence comportant une pastille à semi-conducteurs qui est structurée et dopée de manière appropriée, qui comporte un contact de base, un contact de collecteur et un contact d'émetteur, qui est fabriquée à partir d'un substrat de silicium dopé, enfermé dans un boîtier et dont les contacts sont reliés respectivement aux bornes de base, de collecteur et d'émetteur du boîtier, dans lequel les contacts de base, de collecteur et d'émetteur (2, 3, 4) sont prévus sur le côté supérieur de la pastille (1) à semi-conducteurs, le côté inférieur de la pastille (1) à semi-conducteurs est agencé sur la borne (5) d'émetteur du boîtier (8) conçu comme masse à haute fréquence, le contact (4) d'émetteur est relié à une courte distance à la borne (5) d'émetteur du boîtier (8), et dans lequel le contact (2) de base est relié à la borne (6) de base et le contact (3) de collecteur à la borne (7) de collecteur chaque fois par l'intermédiaire d'au moins un fil de bonding (9).

2. Transistor bipolaire à haute fréquence selon la revendication 1, caractérisé par le fait que le contact (4) d'émetteur est relié à la borne (5) d'émetteur du boîtier (8) par l'intermédiaire d'au moins un fil de bonding (9).

3. Transistor bipolaire à haute fréquence selon la revendication 1, caractérisé par le fait que le contact (4) d'émetteur est relié à la borne (5) d'émetteur du boîtier (8) en passant à travers la pastille (1) à semi-conducteurs.

4. Transistor bipolaire à haute fréquence selon l'une des revendications 1 à 3, caractérisé par le fait que le substrat de silicium de la pastille (1) à semi-conducteurs est à dopage p.

5. Transistor bipolaire à haute fréquence selon l'une des revendications 1 à 4, caractérisé par le fait que le boîtier (8) est un boîtier de type CMS.

6. Transistor bipolaire à haute fréquence selon l'une des revendications 1 à 5, caractérisé par le fait que le boîtier (8) est un boîtier en plastique.

7. Transistor bipolaire à haute fréquence selon l'une des revendications 1 à 6, caractérisé par le fait que l'on fait sortir plusieurs fois hors du boîtier (8) la borne (5) d'émetteur du boîtier (8).
